Europäisches Patentamt

(19) European Patent Office

Office européen des brevets

(11) Publication number: **0 055 530**
**B1**

(12) **EUROPEAN PATENT SPECIFICATION**

(45) Date of publication of patent specification: **05.03.86**

(51) Int. Cl.⁴: **H 01 L 27/14, H 04 N 3/15**

(21) Application number: **81305752.8**

(22) Date of filing: **04.12.81**

(54) **Solid-state image sensor.**

(30) Priority: **23.12.80 JP 182359/80**

(43) Date of publication of application:
**07.07.82 Bulletin 82/27**

(45) Publication of the grant of the patent:
**05.03.86 Bulletin 86/10**

(84) Designated Contracting States:
**DE FR GB**

(56) References cited:

**IEEE JOURNAL OF SOLID STATE CIRCUITS,
vol. SC-11, no. 4, August 1976, page 547-550,
New York (USA); M. MAUTHE et al.:
"Antiblooming: a new approach for linear
imagers".**

**PATENTS ABSTRACTS OF JAPAN, vol. 3, no.
34(E-99), 22nd March 1979, page 61 E99, Tokyo
(JP);**

(73) Proprietor: **Kabushiki Kaisha Toshiba
72, Horikawa-cho Saiwai-ku
Kawasaki-shi Kanagawa-ken 210 (JP)**

(72) Inventor: **Suzuki, Nobuo
202 Takanashi-so, 133-3, Yamanouchi
Kamakura-shi Kanagawa-ken (JP)**

(74) Representative: **Freed, Arthur Woolf et al
MARKS & CLERK 57-60 Lincoln's Inn Fields
London WC2A 3LS (GB)**

(56) References cited:
**IEEE JOURNAL OF SOLID STATE CIRCUITS,
vol. SC-15, no. 2, April 1980, pages 255-257,
New York (USA); C.-M. KYUNG et al.: "Pipeline
analog-to-digital conversion with charge-
coupled devices".**

Courier Press, Leamington Spa, England.

## Description

This invention relates to a solid-state image sensor according to the pre-characterising part of claim 1. Such a sensor is known from Patent Abstracts of Japan, Vol. 3, No. 34 (E—99), 22 March ·1979, p. 61E99), Appl. No. 52-76524.

A known solid-state image sensor such as CCD linear image sensor has a photosensing section which includes a plurality of photosensing cells arranged in a row. The sensor further comprises a CCD register disposed parallel to the row of cells, a gate section disposed between the row of cells and the CCD register and an output section connected to the output of the CCD register. The photosensing cells receive an optical information and generate electrical charges. The charges are read out by the gate section and supplied to the CCD register and further to the output section. The output section converts the charges into voltage signals. That is, the output section generates voltage signals which correspond to the optical information.

Let Q1 denote the maximum storage charge of each photosensing cell, and Q2 denote the maximum charge that the CCD register can transfer.

If Q1 is smaller than Q2, the saturated output voltage of the image sensor is determined by Q1. A difference in Q1 is inevitable among the photosensing cells and is usually several percent, despite all the cells are formed on the same semiconductor substrate in such way as to have the same structure. The image sensor therefore generates voltage signals whose saturated levels differ by several percent. As a result, the voltage signals have a noise component in the vicinity of the saturated output level. In short, the sensor generates output signals of poor quality.

Conversely, if Q1 is greater than Q2, the saturated output voltage of the image sensor is determined by Q2. In case one photosensing cell generates an electrical charge greater than Q2, the excessive portion of the charge will be added in the CCD register to the charge of the next photosensing cell. This invites a kind of undesirable "blooming" phenomenon.

As mentioned above, the known solid-state image sensor cannot provide good saturation characteristics, no matter whether the maximum storage charge Q1 of the photosensing section is smaller or greater than the maximum transfer charge Q2. Its output signals representing an optical information have but poor quality.

It is an object of the present invention as claimed to provide a solid-state image sensor which generates output signals of good saturation characteristics and which can therefore generates high-quality image signals even when its photosensing section receives more light than it can store.

A solid-state image sensor according to the invention comprises a semiconductor substrate, photosensing means formed on the substrate for generating an electrical charge corresponding to the amount of light it receives and for storing the electrical charge and transfer means connected to the photosensing means for reading the charge from the photosensing means at a predetermined time and for transferring the same. The maximum storage charge Q1 of each photosensing means is not greater than the maximum transferable charge Q2 that the transfer means may transfer. The charge is applied from the transfer means to output means through charge control means. For each photosensing means the charge control means applies to the output means only an electrical charge not more than a predetermined constant maximum output charge Q3, which is not more than Q1. The output means converts the charge from the charge control means into an electric signal.

This invention can be more fully understood from the following detailed description when taken in conjunction with the accompanying drawings, in which:

Fig. 1 is a block diagram of a CCD linear image sensor according to one embodiment of this invention;

Fig. 2 is a plan view showing a charge control section, the last stage of a transfer section and peripheral circuits thereof—all used in the image sensor of Fig. 1;

Figs. 3, 4 and 5 are sectional views of the image sensor of Fig. 2, taken along line III—III, line IV—IV and line V—V, respectively; and

Figs. 6A and 6B are sectional views corresponding to Fig. 5 and schematically illustrating a potential well and a potential barrier both formed in a semiconductor substrate.

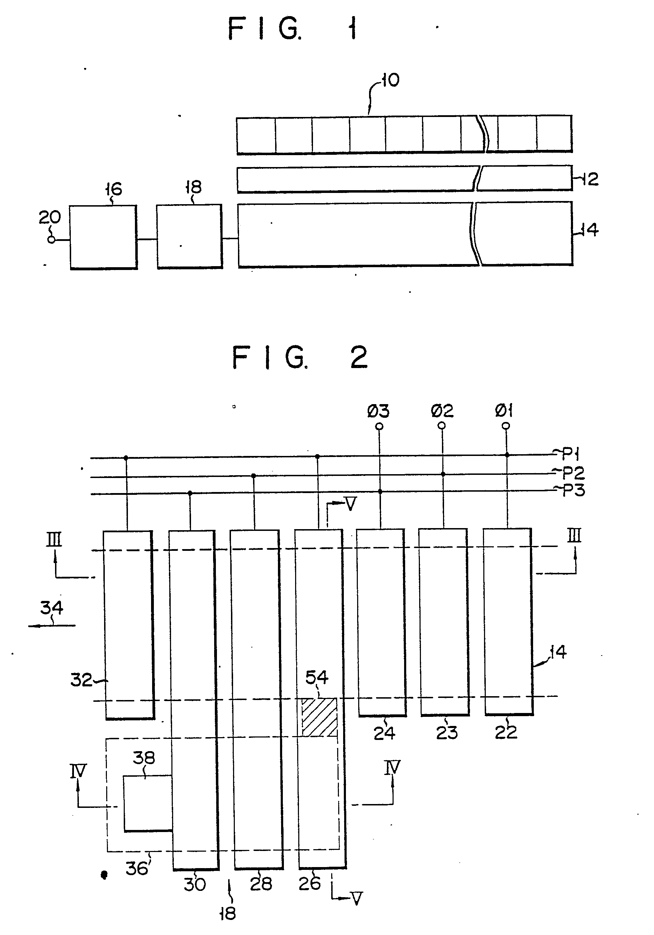

Fig. 1 schematically shows a CCD linear image sensor according to the present invention. A photosensing section 10 comprises, for example, 2,000 to 3,000 photosensing cells which are arranged in a row and which correspond each to a picture element. A gate section 12 is disposed parallel to the photosensing section 10. A transfer section 14, for example, a CCD register, is disposed along the gate section 12. These sections 10, 12 and 14 are formed on, for instance, one P⁻-type chip.

Upon receiving light or optical information each of the photosensing cells accumulates carriers of a predetermined polarity, e.g. electrons, the number of which is substantially proportional to the intensity of the light. When the gate voltage applied to the gate section 12 changes, the gate section 12 is opened (referred to as "gate on"). The electrons or signal charge is then transferred through the gate section 12 to the CCD register 14. That is, the signal charge is read out from the photosensing section 10. When the reading of signal charge is completed, the gate section 12 is closed (referred to as "gate off") by the known method. In the CCD register 14 the signal charges from the photosensing cells of the photosensing section 10 are shifted step by step to the output of the CCD register 14 as transfers signals such as three-phase clock pulses are supplied to the CCD register 14.

Here, let Q1 denote the maximum storage charge of each photosensing cell and Q2 denote the maximum charge that the CCD register 14 can transfer. Then, it is preferred that the following relation stand:

$$Q1 < Q2 \qquad (1).$$

The output of the CCD register 14 is coupled to an output section 16 through a charge control section 18. Both sections 16 and 18 are formed on the abovementioned $P^-$-type chip. The charge control section 18 receives the signal charges from the CCD register 14 and supplies to the output section 16 only those of the signal charges which are not greater than a predetermined maximum charge Q3. The output section receives the signal charges from the charge control section 18 and converts them into electric signals. Preferably, the maximum charge Q3 has the following relation with the maximum storage charge Q1 of each photosensing cell:

$$Q3 < Q1 \qquad (2).$$

Thus, when the signal charge applied to the charge control section 18 is greater than Q3, the section 18 takes the excessive portion of charge from the input signal charge and supplies to the output section 16 a charge not greater than Q3. In other words, the charge control section 18 eliminates an excessive portion, if any, of an input signal charge so as to supply an output signal charge which does not exceed the predetermined maximum value Q3. The output signals of the output section 16 are transmitted through an output terminal 20 to an external circuit (not shown) such as an amplifier.

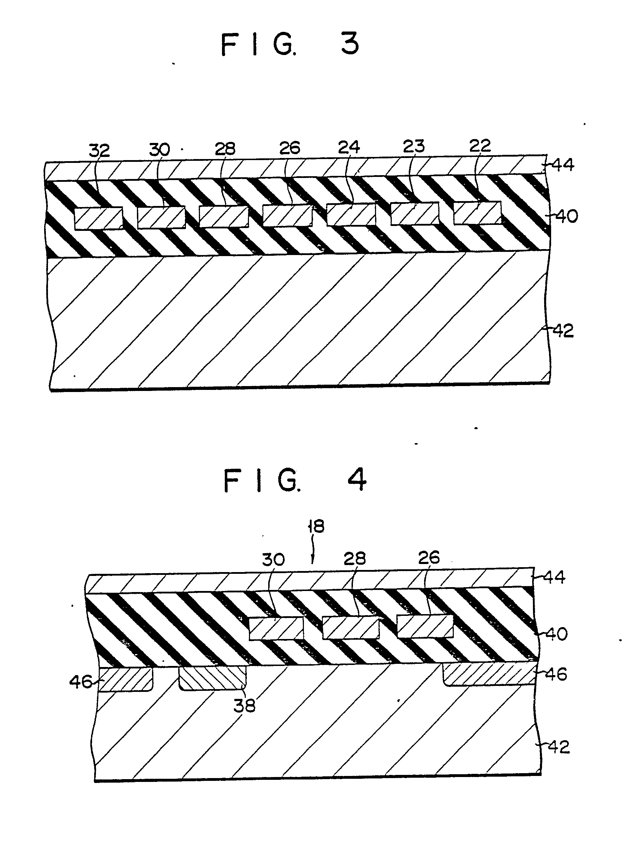

Fig. 2 shows how the last stage of the CCD register 14, the charge control section 18 and the peripheral circuits for them are arranged. Figs. 3 to 5 are sectional views of the image sensor of Fig. 2, taken along line III—III, line IV—IV and line V—V, respectively.

Now referring to Figs. 2 to 5, the CCD linear image sensor of Fig. 1 will be described more in detail. As shown in Fig. 2, the last stage of the CCD register 14 has three transfer electrodes 22, 23 and 24. Three transfer electrodes 26, 28 and 30 are formed in the area corresponding to the charge control section 18. Another transfer electrode 32 is disposed adjacent and parallel to the electrode 30 of the charge control section 18. Through the transfer electrode 32 a signal charge is supplied to the output section 16 from the last stage of the CCD register 14. The electrodes 22, 26 and 32 are connected to a first signal line P1 for supplying a clock pulse φ1 of a first phase. The electrodes 23 and 28 are connected to a second signal line P2 for supplying a clock pulse φ2 of a second phase. The electrodes 24 and 30 are connected to a third signal line P3 for supplying a clock pulse φ3 of the third phase. Thus, when clock pulses φ1, φ2 and φ3 are supplied respectively via the signal lines P1, P2 and P3, a signal charge is shifted from the last stage of the CCD register 14 in the direction of arrow 34. The electrodes 26, 28 and 30 of the charge control section 18 extend substantially at right angles to the charge transfer direction 34. Below these electrodes 26, 28 and 30 there is provided a charge control region 36 including a drain 38. Put in contact with the region 36 and located below the transfer electrode 26 is a P-type layer 54 for controlling the charge to be supplied to the output section 16. (The layer 54, hatched for illustration purpose, will later be described in detail.)

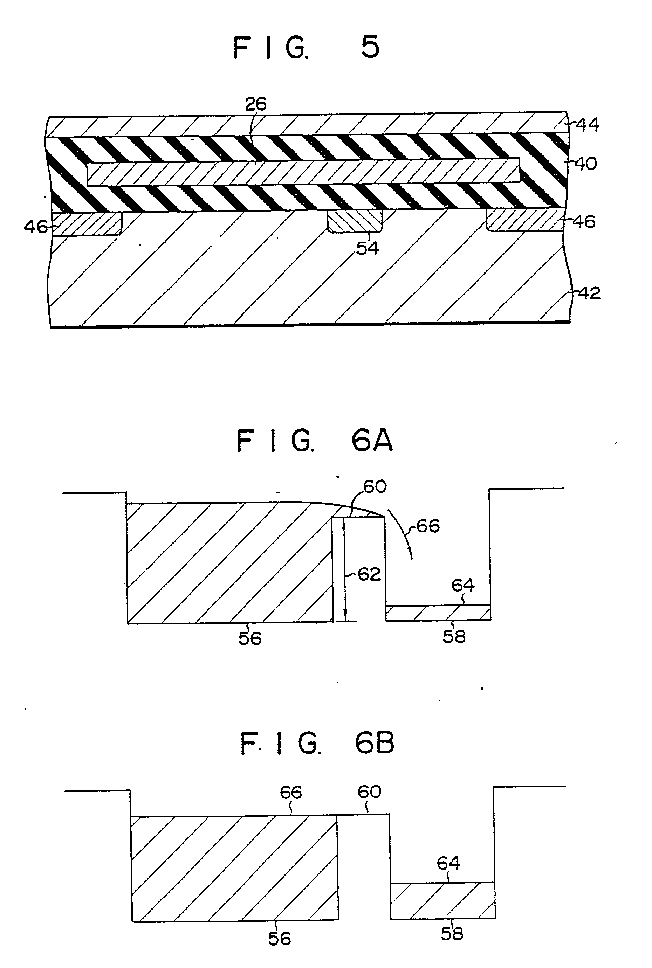

As illustrated in Fig. 3, the electrodes 22, 23, 24, 26, 28, 30 and 32 and other electrodes (not shown) are formed in an insulation layer 40 which is formed on, for example, a $P^-$-type silicon substrate 42. On the insulation layer 40 a light shielding film 44 is formed which is made of a metal such as aluminum. As shown in Fig. 4, P-type layers 46 having a high impurity concentration are formed in the silicon substrate 42 and in contact with the insulation layer 40. The $P^+$ layers 46 function as channel stoppers. The above-mentioned drain layer 38 is of N-type and has a high impurity concentration. The $N^+$ layer 38 is formed in the silicon substrate 42 and in contact with the insulation layer 40 and is located close to one of the $P^+$ layers 46. The drain layer 38 serves to discharge the excessive portion of a signal charge, which is supplied from the charge control section 18 (Fig. 1).

As shown in Fig. 5, two $P^+$-type layers or channel stoppers 46 are formed in the silicon substrate 42 and in contact with the insulation layer 40 and lie below the end portions of the transfer electrode 26, respectively. The above-mentioned P-type layer 54 is formed in the silicon substrate 42 and in contact with the insulation layer 40. The P-type layer 54 hax a lower impurity concentration than that of the channel stoppers 46 so that it may provide a potential barrier which is lower than the potential level of either channel stopper 46. The potential level of the P-type layer 54 determines the maximum charge Q3 that the charge control section 18 can supply to the output section 16 (Fig. 2). That is, the maximum charge Q3 is determined to be not greater than the maximum storage charge Q1 of each photosensing cell. In this embodiment, the difference in Q1 among the cells of the photosensing section 10, which is several percent, is taken into consideration, and Q3 has the following value:

$$Q3 = 0.8 \times Q1 \qquad (3).$$

Now it will be described how the CCD linear image sensor operates. When the photosensing section 10 receives an optical information, the photosensing cells accumulate signal charges. These signal charges are written into the CCD register 14 when the gate section 12 is turned on. As mentioned above the maximum charge Q2 that the CCD register 14 can transfer is greater than the maximum storage charge Q1 of each cell of the photosensing section 10. Accordingly, the

signal charge read from any photosensing cell can be transferred through the CCD register 14. The signal charges are transferred through the CCD register 14 every time three clock pulses φ1, φ2 and φ3 are supplied to the CCD register 14. At this time, potential wells 56 and 58 are made in the silicon substrate 42, i.e. the charge control section 18, as schematically illustrated in Fig. 6A. Between the wells 56 and 58 and below the P-type layer 54 there is formed a potential barrier 60 the height 62 of which is controlled by the P-type layer 54. The height 62 of the potential barrier 60 determines the maximum charge Q3 which the charge control section 18 can supply to the output section 16 and which is smaller than Q1 as given in formula (2).

Thus, if a signal charge supplied to the charge control section 18 from the CCD register 14 is greater than the maximum charge Q3, the excessive portion of the signal charge will overflow the barrier 60 into the potential well 58 in the direction of arrow 66 as shown in Fig. 6A. The excessive charge 64 accumulated in the potential well 58 as shown in Fig. 6B is discharged through the drain layer 38 (Figs. 1 and 4) after the completion of said charge-overflowing. The charge 66 left in the potential well 56, which is substantially equal to Q3, is transferred to the output section 16 when three clock pulses φ1, φ2 and φ3 are supplied to the CCD register 14. The output section 16 converts the charge 66 into an electric signal. Let Q and $Q_{out}$ denote an input signal charge and an output signal charge of the charge control section 18, respectively. Then, the output signal charge $Q_{out}$ is given as follows:

$$Q_{out} = \begin{cases} Q & \text{(when } 0 \leqq Q \leqq Q3) \\ Q3 & \text{(when } Q3 < Q \leqq Q1) \end{cases} \quad (4).$$

Therefore, the charge control section 18 generates a signal charge which is not greater than Q3 no matter how large or small the input signal charge is. The maximum charge Q3 is smaller than the maximum storage charge Q1 of each cell of the photosensing section 10 as given in formula (2). The charge control section 18 can thus remove from an input signal charge a noise component which corresponds to the difference in Q1 among the cells of the photosensing section 10. The electric signals generated by the output section 16 therefore have no noise component and serve to reproduce an image of an improved quality. Moreover, since the maximum charge Q2 that the CCD register 14 can transfer is greater than the maximum storage charge Q1 of each cell, as given in inequality (1), a signal charge generated in every cell of the photosensing section 10 can be written into the CCD register 14. In other words, a signal charge greater than Q2 is never written into the CCD register 14. Thus, no blooming phenomenon takes place in the CCD register 14.

As mentioned above, the solid-state image sensor of the present invention can prevent blooming phenomenon even when its photosensing cells receive more light than they can absorb and can therefore generate high-quality image signals.

The invention may apply not only to a linear image sensor but also to an area image sensor with photosensing cells arranged in the form of a matrix. Also in the case of an area image sensor, it is sufficient to connect only one charge control section to the last stage of a transfer section.

Further, the potential barrier for controlling the charge to be applied to the output section 16 may be provided by another layer than the P-type layer 54. For instance, that portion of the insulation layer which lies above that portion of the substrate in which the potential barrier is to be provided may be made thicker than the other portions, thus forming a potential barrier in said portion of the substrate.

Still further, the drain layer 38 may be provided close to the transfer electrode 26 so that the transfer electrodes 28 and 30 of the charge control section 18 may be omitted and the entire structure may thus be simplified. Moreover, one or more charge control sections may be provided in addition to the charge control section 18, and all the charge control sections may be cascade-connected.

## Claims

1. A solid-stage image sensor having photosensing means (10) formed on a semiconductor substrate (42) for generating an electrical charge corresponding to the amount of light received and for storing the electrical charge, transfer means (14) for reading the charge from the photosensing means at a predetermined time and transferring the same, and output means (16) connected to the transfer means (14) for converting the electrical charge from the transfer means (14) into an electrical signal, the maximum storage charge Q1 of each photosensing means (10) being not greater than the maximum transferable charge Q2 that said transfer means (14) may transfer characterized in that:
a charge control means (18) is connected between said transfer means (14) and said output means (16) for controlling the output charge of said transfer means (14) so that for each photosensing means the maximum output charge Q3 to be supplied to said output means (16) may be limited to a predeterminable constant value, which is not greater than said maximum storage charge Q1 of each photosensing means.

2. A solid-state image sensor according to claim 1, characterized in that the maximum transferable charge Q2 of said transfer means (14) is preferably greater than the maximum storage charge Q1 of each photosensing means (10).

3. A solid-state image sensor according to claim 1, characterized in that the maximum output charge Q3 to be supplied to said output means (16) is preferably smaller than the maximum storage charge Q1 of each photosensing means (10).

4. A solid-state image sensor according to claim 1, characterized in that said photosensing means (10), transfer means (14) and charge control means (18) are formed on said semiconductor substrate (42) in the form of an integrated circuit.

5. A solid-state image sensor according to claim 1, characterized in that said charge control means (18) comprises first means (54) for storing an electrical charge substantially equal to said maximum output charge Q3 when said transfer means (14) transfers an electrical charge greater than said maximum output charge Q3 and for removing the excessive charge (64) of the transferred electrical charge, which corresponds to the difference between the transferred electrical charge and the maximum output charge Q3, and second means (38) for discharging the excessive charge (64) from the first means (54).

6. A solid-state image sensor according to claim 5, characterized in that said first means (54) forms in said semiconductor substrate (42) a potential barrier (60) having a potential level (62) which corresponds to said maximum output charge Q3, and said excessive charge (64) overflows the potential barrier (60).

7. A solid-state image sensor according to claim 6, characterized in that the potential level (62) of said potential barrier (60) can be set to a predetermined potential level which corresponds to said maximum output charge Q3.

8. A solid-state image sensor according to claim 6, characterized in that said semiconductor substrate (42) has a first conductivity type and a predetermined impurity concentration, and said first means includes a semiconductor layer (54) formed in said semiconductor substrate (42) and having the first conductivity type and an impurity concentration higher than that of said semiconductor substrate (42).

9. A solid-state image sensor according to claim 8, characterized in that said second means includes a semiconductor layer (38) having a second conductivity type substantially opposite to the first conductivity type.

**Patentansprüche**

1. Halbleiterbildsensor mit einer photoempfindlichen Einrichtung (10), gebildet auf einem Halbleitersubstrat (42) zur Erzeugung einer elektrischen Ladung entsprechend der Menge des empfangenen Lichtes und zum Speichern der elektrischen Ladung, mit einer Übertragungseinrichtung (14) zum Lesen der Ladung aus der photoempfindlichen Einrichtung zu einer vorgegebenen Zeit und zur Übertragung dieser, und mit einer Ausgangseinrichtung (16), die mit der Übertragungseinrichtung (14) verbunden ist, um die elektrische Ladung aus der Übertragungseinrichtung (14) in ein elektrisches Signal umzuwandeln, wobei die Maximumspeicherladung Q1 jeder photoempfindlichen Einrichtung (10) nicht größer ist als die maximal übertragbare Ladung Q2, welche die Übertragungseinrichtung (14) übertragen darf, dadurch gekennzeichnet, daß eine Ladungssteuereinrichtung (18) zwischen der Übertragungseinrichtung (14) und der Ausgangseinrichtung (16) angeschlossen ist, um die Ausgangsladung der Übertragungseinrichtung (14) zu steuern, so daß für jede photoempfindliche Einrichtung die Maximumausgangsladung Q3, welcher der Ausgangseinrichtung (16) zugeführt werden soll, auf einen vorbestimmbaren konstanten Wert begrenzt werden kann, der nicht größer ist als die Maximumspeicherladung Q1 jeder photoempfindlichen Einrichtung.

2. Halbleiterbildsensor nach Anspruch 1, dadurch gekennzeichnet, daß die maximal übertragbare Ladung Q2 der Übertragungseinrichtung (14) vorzugsweise größer ist als die Maximumspeicherladung Q1 jeder photoempfindlichen Einrichtung (10).

3. Halbleiterbildsensor nach Anspruch 1, dadurch gekennzeichnet, daß die Maximum-Ausgangsladung Q3, welche an die Ausgangseinrichtung (16) geliefert werden soll, vorzugsweise kleiner ist als die Maximumspeicherladung Q1 jeder photoempfindlichen Einrichtung (10).

4. Halbleiterbildsensor nach Anspruch 1, dadurch gekennzeichnet, daß die photoempfindliche Einrichtung (10) die Übertragungseinrichtung (14) und die Ladungssteuereinrichtung (18) auf dem Halbleitersubstrat (42) in der Form einer integrierten Schaltung ausgebildet ist.

5. Halbleiterbildsensor nach Anspruch 1, dadurch gekennzeichnet, daß die Ladungssteuereinrichtung (18) eine erste Einrichtung (54) zum Speichern einer elektrischen Ladung aufweist, welche nahezu gleich der Maximumausgangsladung Q3 ist, wenn die Übertragungseinrichtung (14) eine elektrische Ladung überträgt, welche größe ist als die Maximumausgangsladung Q3 und zum Entfernen der überschüssigen Ladung (64) der übertragenen elektrischen Ladung, welche der Differenz zwischen der übertragenen elektrischen Ladung und der Maximumausgangsladung Q3 entspricht, sowie eine zweite Einrichtung aufweist zum Entladen der überschüssigen Ladung (64) aus der ersten Einrichtung (54).

6. Halbleitersbildsensor nach Anspruch 5, dadurch gekennzeichnet, daß die erste Einrichtung (54) in dem Halbleitersubstrat (42) eine Potentialschwelle (60) bildet, mit einem Potentialpegel (62), welcher der Maximumausgangsladung Q3 entspricht, und daß die überschüssige Ladung (64) die Potentialschranke oder -schwelle (60) überfließt.

7. Halbleiterbildsensor nach Anspruch 6, dadurch gekennzeichnet, daß der Potentialpegel (62) der Potentialschranke oder -schwelle (60) auf einen vorgegebenen Potentialpegel gesetzt werden kann, welcher der Maximumausgangsladung Q3 entspricht.

8. Halbleiterbildsensor nach Anspruch 6, dadurch gekennzeichnet, daß das Halbleitersubstrat (42) einen ersten Leitfähigkeitstyp und eine vorgegebene Störstellenkonzentration aufweist, und daß die erste Einrichtung eine Halbleiterschicht (54) enthält, die in dem Halbleitersubstrat (42) gebildet ist und vom ersten Leitfähigkeitstyp ist sowie eine Störsstellenkonzentration aufweist, die höher ist als des Halbleitersubstrats (42).

9. Halbleiterbildsensor nach Anspruch 8, dadurch gekennzeichnet, daß die zweite Einrichtung eine Halbleiterschicht (38) enthält, welche von zweiten Leitfähigkeitstyp ist, welcher im wesentlichen entgegengesetzt zum ersten Leitfähigkeitstyp ist.

**Revendications**

1. Capteur d'images à l'état solide comportant des moyens de détection photoélectrique (10) formés sur un substrat semiconducteur (42) pour engendrer une charge électrique correspondant à la quantité de lumière reçue et pour stocker la charge électrique, des moyens de transfert (14) pour lire la charge dans les moyens de détection photoélectrique à un temps prédéterminé et pour la transférer, et un moyen de sortie (16) connecté aux moyens de transfert (14) pour convertir la charge électrique provenant des moyens de transfert (14) en un signal électrique, la charge de stockage maximale Q1 de chaque moyen de détection photoélectrique (10) étant au plus égale à la charge maximale pouvant être transférée Q2 que les moyens de transfert (14) peuvent transférer, caractérisé en ce que: un moyen de contrôle de charge (18) est connecté entre les moyens de transfert (14) et le moyen de sortie (16) pour contrôler la charge de sortie des moyens de transfert (14) de sorte que pour chaque moyen de détection photoélectrique on puisse limiter la charge de sortie maximale Q3 à fournir au moyen de sortie (16) à une valeur constante pouvant être prédéterminée, qui est au plus égale à la charge de stockage maximale Q1 de chaque moyen de détection photoélectrique.

2. Capteur d'images à l'état solide selon la revendication 1, caractérisé en ce que la charge maximale pouvant être transférée Q2 des moyens de transfert (14) est de préférence supérieure à la charge de stockage maximale Q1 de chaque moyen de détection photoélectrique (10).

3. Capteur d'images à l'état solide selon la revendication 1, caractérisé en ce que la charge de sortie maximale Q3 à fournir au moyen de sortie (16) est de préférence inférieure à la charge de stockage maximale Q1 de chaque moyen de détection photoélectrique (10).

4. Capteur d'images à l'état solide selon la revendication 1, caractérisé en ce que les moyens de détection photoélectrique (10), les moyens de transfert (14) et le moyen de contrôle de charge (18) sont formés sur le substrat semiconducteur (42) sous la forme d'un circuit intégré.

5. Capteur d'images à l'état solide selon la revendication 1, caractérisé en ce que le moyen de contrôle de charge (18) comprend un premier moyen (54) pour stocker une charge électrique essentiellement égale à la charge de sortie maximale Q3 quand les moyens de transfert (14) transfèrent une charge électrique supérieure à la charge de sortie maximale Q3 et pour retirer la charge en excès (64) de la charge électrique transférée, qui correspond à la différence entre la charge électrique transférée et la charge de sortie maximale Q3, et un second moyen (38) pour évacuer la charge an excès (64) du premier moyen (54).

6. Capteur d'images à l'état solide selon la revendication 5, caractérisé en ce que le premier moyen (54) forme dans le substrat semiconducteur (42) une barrière de potentiel (60) ayant un niveau de potentiel (62) qui correspond à la charge de sortie maximale Q3, et en ce que la charge en excès (64) franchit la barrière de potentiel (60).

7. Capteur d'images à l'état solide selon la revendication 6, caractérisé en ce que le niveau de potentiel (62) de la barrière de potentiel (60) peut être réglé à un niveau de potentiel prédéterminé qui correspond à la charge de sortie maximale Q3.

8. Capteur d'images à l'état solide selon la revendication 6, caractérisé en ce que le substrat semiconducteur (42) a un premier type de conductivité et une concentration d'impuretés prédéterminée, et en ce que le premier moyen comprend une couche semiconductrice (54) formée dans le substrat semiconducteur (42) et ayant le premier type de conductivité et une concentration d'impuretés supérieure à celle du substrat semiconducteur (42).

9. Capteur d'images à l'état solide selon la revendication 8, caractérisé en ce que le second moyen comprend une couche semiconductrice (38) ayant un second type de conductivité essentiellement inverse du premier type de conductivité.

0 055 530

# FIG. 1

# FIG. 2

1

0 055 530

# F I G. 3

# F I G. 4

# F I G. 5

# F I G. 6A

# F. I G. 6B